# FASCICULE DE BREVET EUROPEEN

(11) **EP 3 414 775 B1**
(45) Date de publication et mention de la délivrance du brevet: **11.09.2019**
(21) Numéro de dépôt: 17707380.6
(22) Date de dépôt: 03.02.2017
(51) Int. Cl.: H01L 21/311, H01L 21/768

(54) **PROCEDE DE REALISATION DE CONNEXIONS D'UNE PUCE ELECTRONIQUE**
VERFAHREN ZUR HERSTELLUNG VERTIKALER VERBINDUNGEN AUF EINEM CHIP
METHOD OF FABRICATING VIAS ON A CHIP

(30) Priorité: 09.02.2016 FR 1650994
(43) Date de publication de la demande: 19.12.2018
(73) Titulaire: Commissariat à l'énergie atomique et aux énergies alternatives, 75015 Paris (FR)
(72) Inventeur: POSSEME, Nicolas, 38360 Sassenage (FR); MAZEL, Yann, 69007 Lyon (FR)
(74) Mandataire: Cabinet Beaumont
(86) Numéro de dépôt international: PCT/FR2017/050260
(87) Numéro de publication internationale: WO 2017/137682

(56) Documents cités:
- FR-A1- 2 941 560
- US-A1- 2008 121 619
- US-A1- 2008 146 036
- US-A1- 2011 053 371

## Description

### Domaine

La présente demande concerne le domaine de la fabrication de puces électroniques, et en particulier un procédé de réalisation de connexions conductrices entre des éléments d'une puce électronique.

### Exposé de l'art antérieur

Une puce électronique comprend des circuits électroniques formés dans et sur une plaquette semiconductrice. Dans ces circuits électroniques, des composants élémentaires tels que des transistors, des diodes, des condensateurs, etc., sont interconnectés par des connexions conductrices.

Lors de la fabrication de la puce, les composants élémentaires sont réalisés dans un premier temps. Ces composants élémentaires sont munis de contacts situés sur une face de la plaquette. Les connexions sont formées dans un deuxième temps. Ces connexions sont couplées aux composants élémentaires par l'intermédiaire des contacts et sont séparées les unes des autres par un matériau isolant électriquement.

L'article de N. Posseme et al, intitulé "Residue growth on metallic hard mask after dielectric etching in fluorocarbon based plasmas. II. Solutions" (J. Vac. Sci. Technol. B 29 (1), Jan/Feb 2011), décrit un procédé de réalisation de connexions séparées par des matériaux isolants. Dans ce procédé, les matériaux isolants sont gravés à travers un masque. De façon à retirer le masque sans détériorer les matériaux isolants utilisés dans le procédé, le masque est réalisé à base de métaux.

US 2011/053371 concerne un procédé de nettoyage d'un trou d'interconnexion gravé en utilisant une masque dur métallique, comprenant une étape de recuit sous vide après l'étape de la gravure.

FR 2 941 560 se rapporte à un procédé pour éviter la formation, sur une couche à base d'un métal ayant été exposée à un plasma contenant du fluor, de résidus oxyfluorures métalliques.

D'une manière plus générale, des masques à base de métaux sont utilisés pour graver un matériau isolant dans des procédés connus de réalisation de connexions. Après gravure, il arrive que des corpuscules ou agrégats apparaissent sur le masque et dans les zones gravées. Ces agrégats sont à l'origine de défauts qui compromettent la fiabilité des procédés connus.

Ainsi, il existe un besoin d'un procédé permettant la mise en oeuvre d'un masque à base de métaux pour réaliser des connexions séparées par des matériaux isolants.

### Résumé

Ainsi, un objet d'un mode de réalisation est de pallier tout ou partie des inconvénients décrits ci-dessus.

Un objet d'un mode de réalisation est de former des connexions en permettant l'utilisation d'un masque à base de métaux pour graver un matériau isolant, tout en limitant la formation d'agrégats après l'étape de gravure.

Ainsi, un mode de réalisation prévoit un procédé de réalisation de connexions conductrices d'une puce électronique, comprenant les étapes successives suivantes : a) déposer une couche isolante sur une face d'une plaquette ; b) réaliser une couche à base d'au moins un métal recouvrant la couche isolante et munie de premières ouvertures ; c) graver des deuxièmes ouvertures dans la couche isolante dans le prolongement des premières ouvertures par gravure plasma à base d'au moins un composé halogéné ; d) exposer l'ensemble de la structure obtenue après l'étape c) à de l'oxygène, à un mélange d'hydrogène et d'azote, ou à un mélange de méthane et d'azote ; e) recuire sous vide ledit ensemble ; et f) former, après l'étape d), les connexions conductrices dans les deuxièmes ouvertures.

Selon un mode de réalisation, à l'étape d), la pression est supérieure à 1,3 Pa.

Selon un mode de réalisation, la durée de l'étape d) est supérieure à 5 s.

Selon un mode de réalisation, à l'étape e), ledit ensemble est recuit à une température supérieure à 100 °C.

Selon un mode de réalisation, à l'étape e), ledit ensemble est recuit sous une pression inférieure à 300 Pa.

Selon un mode de réalisation, à l'étape e), ledit ensemble est recuit en présence de gaz comprenant de l'hydrogène et/ou des gaz inertes.

Selon un mode de réalisation, à l'étape e), ledit ensemble est recuit pendant une durée comprise entre 1 min et 10 min.

Selon un mode de réalisation, le composé halogéné est un composé fluoré et la couche à base d'au moins un métal est une couche comprenant au moins 50 % en masse de titane.

Selon un mode de réalisation, la couche isolante est une couche de SiOCH et à l'étape e), ledit ensemble est recuit à une température inférieure à 300 °C.

Selon un mode de réalisation, la couche de SiOCH est poreuse et a une porosité comprise entre 20 % et 50 %.

Selon un mode de réalisation, la couche isolante est en oxyde de silicium.

Selon un mode de réalisation, les étapes c), d) et e) sont réalisées dans un même réacteur.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A à 1F illustrent des étapes d'un procédé de réalisation de connexions d'une puce ; et
les figures 2A et 2B illustrent un mode de réalisation d'étapes d'un procédé de réalisation de connexions d'une puce.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, les composants élémentaires de circuits d'une puce électronique ne sont pas représentés.

Dans la description qui suit, lorsque l'on fait référence à des qualificatifs de position relative, tel que le terme "dessus", il est fait référence à l'orientation de l'élément concerné dans les figures concernées.

Dans la description qui suit, on appelle agrégats des corpuscules dont une dimension est supérieure à 5 nm.

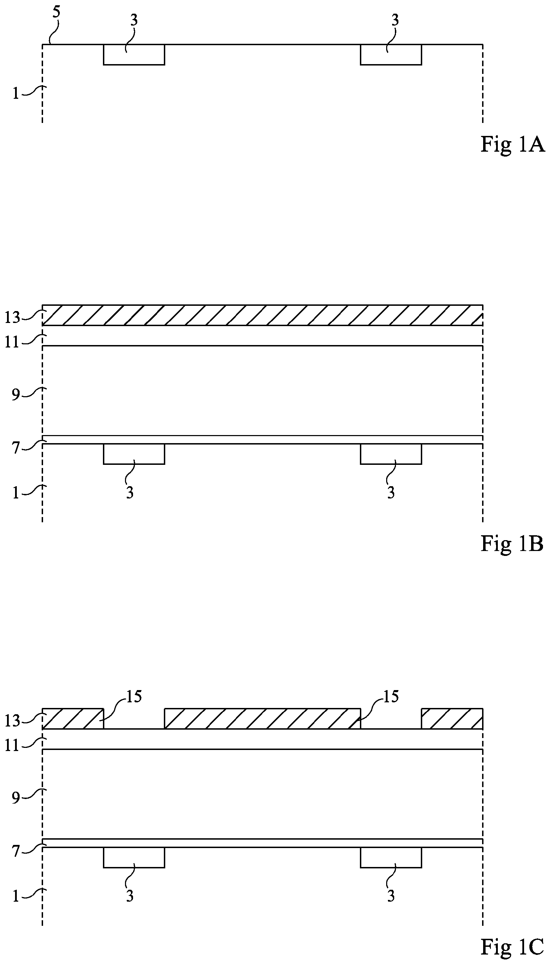

Les figures 1A à 1F sont des vues schématiques en coupe illustrant des étapes d'un procédé de réalisation de connexions conductrices d'une puce. Selon un mode de réalisation, les connexions obtenues sont séparées par des isolants ayant une permittivité diélectrique faible, c'est-à-dire une permittivité diélectrique relative inférieure à environ 3. Cette permittivité relative faible permet d'éviter que des signaux électriques transmis par des connexions voisines se perturbent mutuellement lors du fonctionnement de la puce.

La figure 1A représente une plaquette 1 de semiconducteur. Des composants élémentaires non représentés sont formés dans et sur la plaquette 1. Ces composants sont munis de contacts 3 disposés au niveau d'une face 5 de la plaquette 1. Seuls deux contacts 3 sont représentés. La face 5 est plane et les contacts 3 affleurent la face 5.

La figure 1B illustre plusieurs étapes successives. Une couche isolante 7 de carbonitrure de silicium (SiCN) est déposée sur la face 5. Ensuite, une couche isolante 9 en oxyde de silicium carboné et hydrogéné (SiOCH) est formée sur la couche 7. La couche 7 est recouverte d'une couche 11 d'oxyde de silicium. Les couches 7, 9 et 11 peuvent être formées par dépôt en phase vapeur assisté par plasma. On recouvre alors la couche 11 par une couche 13 de nitrure de titane (TiN).

En figure 1C, des ouvertures 15 sont gravées dans la couche 13 au-dessus des contacts 3. La gravure peut être réalisée à travers des ouvertures formées dans une couche de masquage non représentée. Cette couche de masquage est ensuite éliminée par gravure.

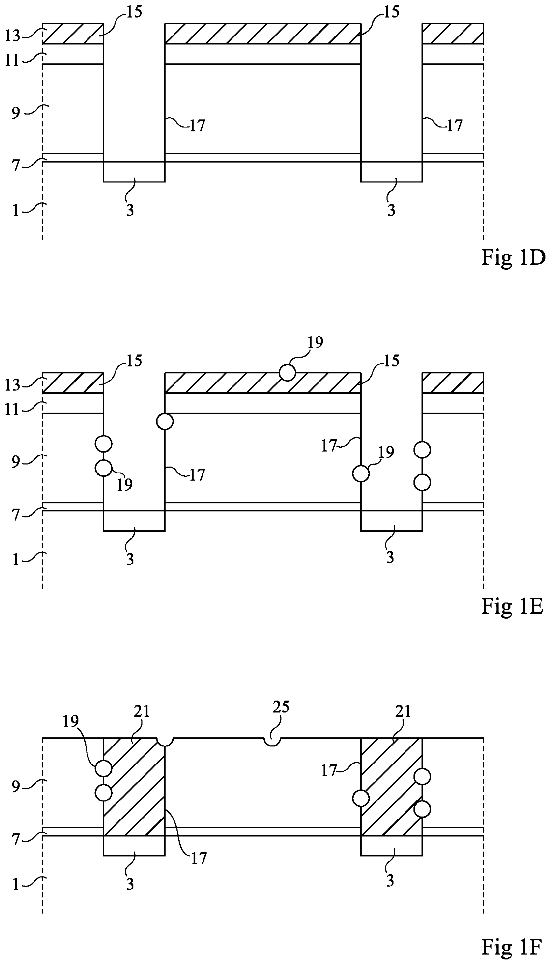

A l'étape illustrée en figure 1D, des ouvertures 17 dans la couche 11 d'oxyde de silicium et la couche 9 de SiOCH sont gravées par plasma dans le prolongement des ouvertures 15. La gravure des couches 11 et 9 peut être réalisée avec un plasma à base d'un hydrofluorocarbure, appelé plasma HFC par la suite, par exemple un plasma à base d'un fluorocarbure tel que l'octafluorobutane C₄F₈. La couche 13 de TiN munie des ouvertures 15 constitue ainsi un masque. La gravure est réalisée jusqu'à la couche 7 de SiCN qui constitue une couche d'arrêt de gravure. Ensuite, les parties de la couche 7 situées sur les contacts 3 sont gravées. La couche 7 peut être gravée par un plasma à base d'hydrofluorocarbures tels que le tétrafluorure de carbone (CF₄₎ et le fluorométhane (CH₃F).

En figure 1E, l'ensemble a été stocké et exposé à l'air dans l'attente des étapes suivantes du procédé. L'attente peut être supérieure à 3 h. Des agrégats 19 apparaissent sur les parois des parties gravées et sur la surface de la couche 13.

La figure 1F illustre une étape ultérieure du procédé. Un dépôt métallique, remplissant notamment les ouvertures 17, a été réalisé sur l'ensemble de la structure. Les couches 13 et 11 et des parties du dépôt métallique ont été retirées par un procédé de polissage mécanochimique. La couche 11 sert de couche d'arrêt de polissage. Des portions 21 du dépôt métallique demeurent dans les ouvertures 17 et constituent des connexions reliées aux contacts 3. On a obtenu des connexions conductrices 21 séparées par des portions de la couche isolante 9 de SiOCH.

La présence des agrégats 19 est à l'origine de défauts. En particulier, les agrégats 19 présents dans les ouvertures 17 peuvent perturber l'étape de dépôt métallique et altérer la qualité des connexions 21. En outre, les agrégats 19 présents dans les parties gravées peuvent altérer la qualité de la couche isolante 9 de SiOCH, et, lors du fonctionnement de la puce, des signaux transmis par une connexion 21 risquent d'être perturbés par des signaux circulant par une connexion 21 voisine. De plus, les agrégats présents sur la surface de la couche 13 perturbent le procédé de polissage et provoquent des défauts 25 sur la face de la plaquette. La présence des défauts peut compromettre le fonctionnement de la puce.

Les inventeurs ont démontré que des résidus fluorés sont présents sur les surfaces de la structure obtenue après les étapes de gravure des couches 7 et 9 par des plasmas HFC. Les inventeurs ont démontré en outre que les agrégats 19 proviennent d'une interaction entre le titane de la couche 13, les résidus fluorés et l'humidité de l'air. Par exemple, les inventeurs ont constaté que des agrégats apparaissent à la surface d'une couche de TiN exposée successivement à un plasma à base de C₄F₈ pendant au moins 60 s puis à l'air pendant une durée supérieure à 2 min.

Afin de limiter la formation des agrégats, on peut prévoir une étape de traitement après l'étape de gravure illustrée en figure 1D et avant la phase d'attente décrite en relation avec la figure 1E. Cette étape de traitement peut être une phase d'exposition de l'ensemble à de l'oxygène, à un mélange d'hydrogène et d'azote, ou à un mélange de méthane et d'azote, l'étape de traitement étant réalisée avant exposition à l'air ambiant. L'étape de traitement peut aussi être une phase de ventilation de l'ensemble par de l'air sec pendant une durée d'une dizaine de minutes. Cependant, cette étape de traitement ne permet pas une réduction suffisante du nombre d'agrégats.

Ainsi, le procédé décrit en relation avec les figures 1A à 1F présente un problème de fiabilité.

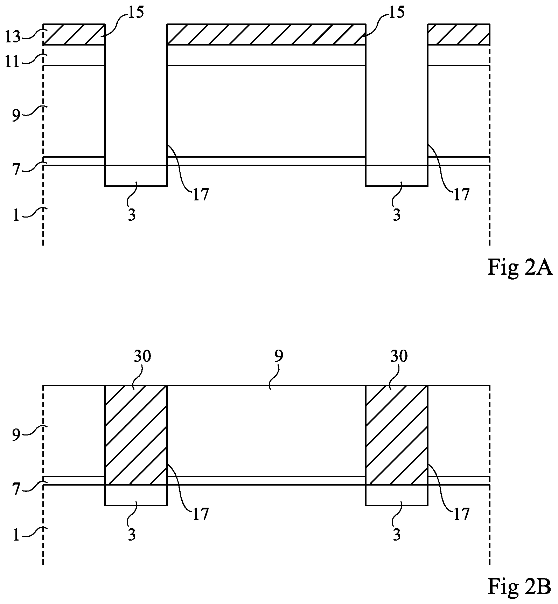

Les figures 2A et 2B illustrent des étapes d'un mode de réalisation d'un procédé de fabrication de connexions d'une puce.

Les étapes précédant l'étape illustrée en figure 2A sont similaires aux étapes illustrées par les figures 1A à 1D, à savoir
a) déposer successivement des couches isolantes 7, 9 et 11 respectivement de SiCN, de SiOCH et d'oxyde de silicium sur une face d'une plaquette 1 comprenant des contacts 3 affleurant la face, puis déposer une couche 13 de TiN ;
b) graver des ouvertures dans la couche 13 de TiN ; et
c) graver les couches 11, 9 et 7 par un plasma HFC.

A titre d'exemple, la couche isolante 7 a une épaisseur comprise entre 5 nm et 30 nm. La couche isolante 9 peut avoir une épaisseur comprise entre 30 nm et 200 nm. La couche 11 en oxyde de silicium peut avoir une épaisseur comprise entre 10 nm et 50 nm. Selon un exemple, la couche 13 en TiN a une épaisseur comprise entre 5 nm et 50 nm.

A l'étape illustrée en figure 2A, l'ensemble de la structure obtenue après l'étape c) a été recuit sous vide sous une pression inférieure à 300 Pa (environ 2 mmHg). Les gaz résiduels présents pendant le recuit peuvent être de l'hydrogène ou des gaz inertes tels que l'azote, l'hélium ou l'argon. Le recuit a lieu à une température supérieure à 100 °C. La température du recuit est inférieure à 300 °C afin d'éviter d'endommager la couche d'isolant 9 en SiOCH. La durée du recuit peut être comprise entre 1 min et 10 min.

Par la suite, l'ensemble est exposé à l'air ambiant au cours de phases d'attente et de stockage. Les inventeurs ont constaté l'absence de formation d'agrégats après une phase d'exposition à l'air pouvant atteindre 18 h. Il semble que les résidus fluorés présents sur les parois à la fin de l'étape précédente soient partiellement éliminés par le recuit.

Dans une variante, une étape supplémentaire de traitement est prévue après l'étape c) de gravure et avant l'étape de recuit illustrée en figure 2A. A cette étape de traitement, l'ensemble de la structure obtenue après l'étape c) est exposé à de l'oxygène, à un mélange d'hydrogène et d'azote, ou à un mélange de méthane et d'azote, sous une pression supérieure à 1,3 Pa (environ 10 mTorr), de préférence comprise entre 1,3 Pa et 6,7 Pa (entre environ 10 mTorr et environ 50 mTorr) et pendant une durée supérieure à 5 secondes, de préférence comprise entre 5 s et 30 s. D'autres gaz susceptibles d'éliminer des résidus fluorés peuvent être employés, par exemple des gaz contenant du carbone ou des gaz susceptibles d'éliminer les résidus fluorés par oxydation ou par réduction.

A l'étape illustrée en figure 2B, les ouvertures 17 ont été remplies d'un conducteur tel que du cuivre ou du tungstène et la face a été polie, d'une manière identique à l'étape décrite en relation avec la figure 1F.

On obtient des connexions conductrices 30 reliées aux contacts 3 et séparées par des parties de la couche isolante 9 en SiOCH. Des pistes conductrices disposées sur l'isolant 9 et reliant des connexions 30 peuvent être formées à une étape ultérieure.

Lors du fonctionnement de la puce, des signaux électroniques sont transmis par les pistes vers les connexions 30. La permittivité diélectrique relative du SiOCH peut être inférieure à 3. De ce fait, un signal transmis par une connexion 30 n'est pas perturbé par des signaux transmis par des connexions voisines. Dans une variante, le SiOCH de la couche isolante est poreux et a de ce fait une permittivité diélectrique inférieure à la permittivité diélectrique du SiOCH dépourvu de porosité. La couche isolante en SiOCH poreux peut avoir une porosité comprise entre 20 % et 50 %.

Des modes de réalisation particuliers ont été décrits. Diverses variantes et modifications apparaîtront à l'homme de l'art. En particulier, bien que, dans les modes de réalisation décrits, des isolants soient gravés par des plasmas HCF, des isolants peuvent être gravés au moyen de plasmas à base de tout type de composé halogéné, par exemple des halogénoalcanes tels que des chlorofluorocarbures ou des hydrochlorocarbures.

En outre, bien que, dans les modes de réalisation décrits, la couche isolante 9 soit en SiOCH, la couche isolante 9 peut être en tout autre matériau adapté à être gravé par un plasma à base d'un composé halogéné. A titre d'exemple, la couche isolante 9 est en oxyde de silicium.

De plus, bien que la température utilisée au cours de l'étape de recuit décrite en relation avec la figure 2A soit inférieure à 300 °C afin d'éviter d'endommager la couche isolante 9 de SiOCH, cette température peut avoir une valeur supérieure compatible avec les matériaux mis en oeuvre.

En outre, bien que la couche d'arrêt de gravure 7 soit en SiCN dans des modes de réalisation, cette couche peut être en tout autre matériau adapté au plasma utilisé. A titre d'exemple, la couche d'arrêt de gravure peut être en nitrure de silicium lorsque le plasma utilisé est prévu pour graver un isolant en oxyde de silicium.

De plus, bien qu'une couche d'arrêt de polissage particulière ait été décrite, cette couche peut être omise ou remplacée par toute autre couche adaptée.

De plus, bien que, dans des modes de réalisation décrits précédemment, un masque en TiN soit utilisé, le masque peut être tout masque à base d'au moins un métal, c'est-à-dire contenant une proportion de métal supérieure à 50 % en masse, en particulier tout masque à base d'au moins un métal produisant des agrégats après expositions successives à un plasma halogéné puis à l'air. A titre d'exemples, le masque peut être en nitrure de tantale, en oxyde d'aluminium ou en oxyde d'hafnium, ou le masque peut-être métallique, par exemple en titane ou en tantale.

En outre, bien que des étapes particulières aient été décrites pour réaliser un masque à base d'au moins un métal, ces étapes peuvent être remplacées par tout procédé adapté à former une couche à base d'au moins un métal recouvrant la couche isolante et munie d'ouvertures.

En outre, bien que, dans des modes de réalisation décrits, un seul masque à base d'au moins un métal soit mis en oeuvre, le masque à base d'au moins un métal peut être combiné par exemple à des masques en matériaux organiques. A titre d'exemple, une couche de masquage en matériau organique peut être étendue sur l'ensemble de la structure obtenue après l'étape décrite en relation avec la figure 1C de gravure d'ouvertures dans la couche 13 de TiN. Cette couche de masquage est ensuite gravée pour obtenir un masque organique. Le masque organique, combiné au masque à base de métaux, permet de réaliser une configuration choisie de connexions et de pistes reliant ces connexions.

De plus, dans le mode de réalisation présenté, des pistes reliant des connexions 30 sont formées après l'étape illustrée en figure 2B. Dans une variante, les pistes reliant des connexions 30 peuvent être formées en ajoutant, avant l'étape illustrée en figure 2A, les étapes suivantes :
- graver des ouvertures dans la couche 13 selon la configuration des pistes ; et
- graver à partir de ces ouvertures la couche 11 puis la couche 9 sur une partie de son épaisseur, la gravure pouvant être réalisée par un plasma HFC.
Les pistes peuvent alors être formées en même temps que les connexions au cours de l'étape illustrée en figure 2B.

## Revendications

1. Procédé de réalisation de connexions conductrices (30) d'une puce électronique, comprenant les étapes successives suivantes :
a) déposer une couche isolante (7, 9) sur une face d'une plaquette ;
b) réaliser une couche (13) à base d'au moins un métal recouvrant la couche isolante et munie de premières ouvertures (15) ;
c) graver des deuxièmes ouvertures (17) dans la couche isolante (7, 9) dans le prolongement des premières ouvertures par gravure plasma à base d'au moins un composé halogéné ;
d) exposer l'ensemble de la structure obtenue après l'étape c) à de l'oxygène, à un mélange d'hydrogène et d'azote, ou à un mélange de méthane et d'azote ;
e) recuire sous vide ledit ensemble ; et
f) former, après l'étape e), les connexions conductrices dans les deuxièmes ouvertures.

2. Procédé selon la revendication 1, dans lequel à l'étape d), la pression est supérieure à 1,3 Pa.

3. Procédé selon la revendication 1 ou 2, dans lequel la durée de l'étape d) est supérieure à 5 s.

4. Procédé selon l'une quelconque des revendications 1 à 3, dans lequel à l'étape e), ledit ensemble est recuit à une température supérieure à 100 °C.

5. Procédé selon l'une quelconque des revendications 1 à 4, dans lequel à l'étape e), ledit ensemble est recuit sous une pression inférieure à 300 Pa.

6. Procédé selon l'une quelconque des revendications 1 à 5, dans lequel à l'étape e), ledit ensemble est recuit en présence de gaz comprenant de l'hydrogène et/ou des gaz inertes.

7. Procédé selon l'une quelconque des revendications 1 à 6, dans lequel à l'étape e), ledit ensemble est recuit pendant une durée comprise entre 1 min et 10 min.

8. Procédé selon l'une quelconque des revendications 1 à 7, dans lequel le composé halogéné est un composé fluoré et la couche à base d'au moins un métal est une couche comprenant au moins 50 % en masse de titane.

9. Procédé selon l'une quelconque des revendications 1 à 8, dans lequel la couche isolante (9) est une couche de SiOCH et à l'étape e), ledit ensemble est recuit à une température inférieure à 300 °C.

10. Procédé selon la revendication 9, dans lequel la couche (9) de SiOCH est poreuse et a une porosité comprise entre 20 % et 50 %.

11. Procédé selon l'une quelconque des revendications 1 à 8, dans lequel la couche isolante (9) est en oxyde de silicium.

12. Procédé selon l'une quelconque des revendications 1 à 8, dans lequel les étapes c), d) et e) sont réalisées dans un même réacteur.

## Patentansprüche

1. Verfahren zum Bilden von leitenden Verbindungen (30) eines elektronischen Chips, das die aufeinanderfolgenden Schritte aufweist:
a) Abscheiden einer Isolierschicht (7, 9) auf einer Oberfläche eines Wafers;
b) Ausbilden einer Schicht (13), die aus wenigstens einem Metall besteht, das die Isolierschicht abdeckt und mit ersten Öffnungen (15) versehen ist;
c) Ätzen zweiter Öffnungen (17) in der Isolierschicht (7, 9) ausgerichtet mit den ersten Öffnungen durch Ätzen mit einem Plasma, das aus wenigstens einer halogenierten Verbindung besteht;
d) Aussetzen der Anordnung, die durch die nach Schritt c) erhaltene Struktur gebildet wird, gegenüber Sauerstoff, einem Gemisch aus Wasserstoff und Stickstoff oder einem Gemisch aus Methan und Stickstoff;
e) Tempern der Anordnung im Vakuum; und
f) Ausbilden der leitenden Verbindungen in den zweiten Öffnungen nach Schritt e).

2. Verfahren nach Anspruch 1, wobei bei Schritt d) der Druck größer als 1,3 Pa ist.

3. Verfahren nach Anspruch 1 oder 2, wobei die Dauer von Schritt d) länger als 5 s ist.

4. Verfahren nach einem der Ansprüche 1 bis 3, wobei bei Schritt e) die Anordnung bei einer Temperatur von mehr als 100°C getempert wird.

5. Verfahren nach einem der Ansprüche 1 bis 4, wobei bei Schritt e) die Anordnung unter einem Druck von weniger als 300 Pa getempert wird.

6. Verfahren nach einem der Ansprüche 1 bis 5, wobei bei Schritt e) die Anordnung in Gegenwart von Gas, das Wasserstoff und/oder Inertgase aufweist, getempert wird.

7. Verfahren nach einem der Ansprüche 1 bis 6, wobei bei Schritt e) die Anordnung für eine Dauer im Bereich von 1 min bis 10 min getempert wird.

8. Verfahren nach einem der Ansprüche 1 bis 7, wobei die halogenierte Verbindung ein fluorierter Verbindung ist und die aus wenigstens einem Metall bestehende Schicht eine Schicht ist, die wenigstens 50 Masse-% Titan aufweist.

9. Verfahren nach einem der Ansprüche 1 bis 8, wobei die Isolierschicht (9) eine SiOCH-Schicht ist und bei Schritt e) die Anordnung bei einer Temperatur von weniger als 300°C getempert wird.

10. Verfahren nach Anspruch 9, wobei die SiOCH-Schicht (9) porös ist und eine Porosität im Bereich von 20% bis 50% aufweist.

11. Verfahren nach einem der Ansprüche 1 bis 8, wobei die Isolierschicht (9) aus Siliziumoxid hergestellt ist.

12. Verfahren nach einem der Ansprüche 1 bis 8, wobei die Schritte c), d) und e) in demselben Reaktor durchgeführt werden.

## Claims

1. A method of forming conductive connections (30) of an electronic chip, comprising the successive steps of:
a) depositing an insulating layer (7, 9) on a surface of a wafer;
b) forming a layer (13) made up of at least one metal covering the insulating layer and provided with first openings (15) ;
c) etching second openings (17) in the insulating layer (7, 9) in line with the first openings by etching with a plasma made up of at least one halogenated compound;
d) exposing the assembly formed by structure obtained after step c) to oxygen, to a mixture of hydrogen and nitrogen, or to a mixture of methane and nitrogen;
e) annealing said assembly in vacuum; and
f) forming, after step e), the conductive connections in the second openings.

2. The method of claim 1, wherein at step d), the pressure is greater than 1.3 Pa.

3. The method of claim 1 or 2, wherein the duration of step d) is longer than 5 s.

4. The method of any of claims 1 to 3, wherein at step e), said assembly is annealed at a temperature higher than 100°C.

5. The method of any of claims 1 to 4, wherein at step e), said assembly is annealed under a pressure smaller than 300 Pa.

6. The method of any of claims 1 to 5, wherein at step e), said assembly is annealed in the presence of gas comprising hydrogen and/or inert gases.

7. The method of any of claims 1 to 6, wherein at step e), said assembly is annealed for a duration in the range from 1 min to 10 min.

8. The method of any of claims 1 to 7, wherein the halogenated compound is a fluorinated compound and the layer made up of at least one metal is a layer comprising at least 50% by mass of titanium.

9. The method of any of claims 1 to 8, wherein the insulating layer (9) is a SiOCH layer and at step e), said assembly is annealed at a temperature lower than 300°C.

10. The method of claim 9, wherein the SiOCH layer (9) is porous and has a porosity in the range from 20% to 50%.

11. The method of any of claims 1 to 8, wherein the insulating layer (9) is made of silicon oxide.

12. The method of any of claims 1 to 8, wherein steps c), d), and e) are carried out in a same reactor.
